# EUROPEAN PATENT APPLICATION

(11) **EP 4 642 198 A1**
(43) Date of publication of application: **29.10.2025**
(21) Application number: 23907809.0
(22) Date of filing: 21.12.2023
(51) Int. Cl.: H10K 50/16, H10K 50/81, H10K 50/82, H10K 50/15, H10K 50/11, H10K 50/17, H10K 50/13, H10K 101/10, H10K 101/30

(54) **ORGANIC ELECTROLUMINESCENT ELEMENT**

(30) Priority: 23.12.2022 KR 20220183792
(71) Applicant: Solus Advanced Materials Co., Ltd., Iksan-si, Jeollabuk-do 54584 (KR)
(72) Inventor: MOON, Jonghun, Seongnam-si, Gyeonggi-do 13636 (KR); LEE, Jaehoon, Seongnam-si, Gyeonggi-do 13636 (KR); HAN, Songie, Seongnam-si, Gyeonggi-do 13636 (KR)
(74) Representative: Office Freylinger
(86) International application number: PCT/KR2023/021261
(87) International publication number: WO 2024/136526

(57) **Abstract**

The present invention provides an organic electroluminescent element having optimized efficiency through the maximization of light extraction due to comprising at least two electron transport layers, controlled to have a predetermined refractive index difference, between a light-emitting layer and an electrode.

## Description

### Technical Field

The present invention relates to an organic electroluminescent device having optimized efficiency through the maximization of light extraction by including at least two electron transport layers controlled to have a predetermined refractive index difference between an light emitting layer and an electrode.

### Background Art

In 1965, studies on organic EL devices led to blue electroluminescence which uses anthracene monocrystals, and in 1987, Tang suggested an organic EL device in a two-layered stack structure which includes a hole layer (NPB) and a light emitting layer (Alq3). Afterwards, in order to realize high efficiency and long life characteristics required for commercialization of organic EL devices, a multilayer stack structure that includes, for example, organic layers responsible for hole injection and transporting, organic layers responsible for electron injection and transporting, and an organic layer responsible for inducing combination of the holes and electrons to cause electroluminescence, each having distinctive and subdivided functions, has been suggested. The introduction of the multilayer stack structure improved the performance of the organic EL devices up to the level of commercialization, and such a multilayer stack structure has been expanding its application range from portable radio display products in 1997 to portable information display devices and TV display devices.

The demand for larger displays and higher resolutions has led to challenges, for example, high efficiency and long lifespan, for the organic EL devices. Particularly, the high resolution that may be realized by forming more pixels in the same area results in a decrease in a light emitting area of an organic EL pixel, thus inevitably reducing the lifespan, which has become one of the most important technical challenges to overcome for the organic EL device.

In the organic EL device, when current or voltage is applied to two electrodes, holes are injected into an organic layer at an anode, and electrons are injected into the organic layer at a cathode. When the injected holes and electrons meet, an exciton is formed, and the exciton falls to the ground state, resulting in light emission. Such organic EL devices may be classified, according to an electron spin type of the formed excitons, into fluorescent EL devices in which singlet excitons contribute to light emission and phosphorescent EL devices in which triplet excitons contribute to light emission.

In terms of the electron spin of the excitons that are formed by recombination of electrons and holes, 25 % of singlet excitons and 75 % of triplet excitons are produced. In the fluorescent EL devices which emit light by singlet excitons, the internal quantum efficiency may not theoretically exceed 25 % depending on the production ratio, and the external quantum efficiency is regarded to have a limitation of 5 %. The phosphorescent EL devices which emit light by triplet excitons may improve luminous efficiency by up to four times as compared to fluorescence, when metal complex compounds containing transition metal heavy atoms such as Ir and Pt are used as phosphorescent dopants.

As described above, although the phosphorescent EL devices exhibit higher efficiency than fluorescence in terms of luminous efficiency based on the theoretical fact, in the case of blue phosphorescent devices, except green and red, the development level for phosphorescent dopants having deep blue color purity and high efficiency and hosts having a broad energy gap to satisfy such phosphorescent dopants is insufficient, and thus blue phosphorescent devices have not been commercialized yet, and blue fluorescent devices have been used in products.

In order to improve such characteristics of the organic EL device, research results to increase the stability of the organic EL device by preventing diffusion of holes into an electron transferring layer have been reported. However, to date, no satisfactory result has been obtained.

### Disclosure of Invention

### Technical Problem

The present invention has been made to solve the above-mentioned problems, and an aspect of the present invention is to provide an organic EL device implementing high efficiency through the maximization of light extraction according to a micro-cavity effect by including at least two electron transport layers between an light emitting layer and an electrode, with a controlled difference within a predetermined range between the refractive index of a first electron transport layer adjacent to the light emitting layer and the refractive index of a second transport layer adjacent to the electrode.

Other purposes and advantages of the present disclosure will be clarified by following detailed description and claims.

### Solution to Problem

To achieve the above objectives, the present invention provides an organic electroluminescent device, including a structure in which a first electrode, a hole transport area, a light emitting layer, an electron transport area, and a second electrode are sequentially laminated,
wherein the electron transport area includes at least two layers, the at least two layers including:
a first electron transport layer (ET1) disposed adjacent to the light emitting layer; and
a second electron transport layer (ET2) disposed adjacent to the second electrode, and
in the wavelength range of 460±20 nm, the refractive index (n1) of the first electron transport layer being higher than the refractive index (n2) of the second electron transport layer.

According to an embodiment, in the wavelength range of 460±20 nm, the difference in refractive index (n1 - n2) between the first electron transport layer and the second electron transport layer may be greater than 0 and less than 1.0.

According to an embodiment, in the wavelength range of 460±20 nm, each of the refractive indexes (n1) of the first electron transport layer and the second electron transport layer may be 1.45 to 3.0.

According to an embodiment, in the wavelength range of 460±20 nm, an absolute value of a refractive index difference between the first electron transport layer and the light emitting layer may be from 0 to 1.5.

According to an embodiment, in the wavelength range of 460±20 nm, an absolute value of a refractive index difference between the second electron transport layer and the light emitting layer may be from 0 to 1.5.

According to an embodiment, each of absolute value of HOMO energy of the first electron transport layer and the second electron transport layer may be 4.0 eV or higher.

According to an embodiment, each of absolute value of LUMO energy of the first electron transport layer and the second electron transport layer may be 1.60 eV or higher.

According to an embodiment, an absolute value of a difference between a HOMO energy level of the first electron transport layer and a HOMO energy level of the second electron transport layer may be from 0 to 2.5 eV.

According to an embodiment, an absolute value of a difference between a LUMO energy level of the first electron transport layer and a LUMO energy level of the second electron transport layer may be from 0 to 2.5 eV.

According to an embodiment, an absolute value of a difference between a LUMO energy level of the light emitting layer and a LUMO energy level of the first electron transport layer may be from 0 to 1.5 eV.

According to an embodiment, an absolute value of a difference between a LUMO energy level of the light emitting layer and a LUMO energy level of the second electron transport layer may be from 0 to 1.5 eV.

According to an embodiment, the absolute value of a difference in molecular weight (MW) between the first electron transport layer and the second electron transport layer may be from 0 to 600 g/mol.

According to an embodiment, each of a single energy (S1) of the first electron transport layer and the second electron transport layer may be 1.8 eV or higher.

According to an embodiment, each of a triplet energy (T1) of the first electron transport layer and the second electron transport layer may be 1.6 eV or higher.

According to an embodiment, a lowest energy level among a bonding dissociation energy (BDE) of a ground state of the first electron transport layer and the second electron transport layer may be 0.5 eV or more.

According to an embodiment, the first electron transport layer and the second electron transport layer each may have a dipole moment greater than 0.

According to an embodiment, the first electron transport layer and the second electron transport layer each may have an electronic affinity (EA) of 0.1 eV or more.

According to an embodiment, the first electron transport layer and the second electron transport layer may have an electron mobility (µ) of at least 1×10⁻⁸ cm²/Vs or more in a zero-field.

According to an embodiment, the electron transport area may further comprise at least one layer selected from the group consisting of a hole leakage suppression layer, an auxiliary electron transport layer, and an electron injection layer.

According to an embodiment, the light emitting layer includes the host and a dopant, and a mixing ratio between the host and the dopant may be 70-99.5 : 0.5-30 by weight.

In some embodiments, the organic electroluminescent device may include a plurality of light emitting layer stacks including at least one light emitting layer.

### Advantageous Effects of Invention

According to one or more embodiments of the present invention, an organic EL device may have optimized efficiency through the maximization of light extraction due to comprising at least two electron transport layers, controlled to have a predetermined refractive index difference, between a light-emitting layer and an electrode.

The effects according to the present invention are not limited by the contents exemplified above, and more various effects are included in the present specification.

### BRIEF DESCRIPTION OF DRAWINGS

FIG. 1 is a cross-sectional view illustrating a structure of an organic EL device according to an embodiment of the present invention.
FIG. 2 is a cross-sectional view illustrating a structure of an organic EL device according to an another embodiment of the present invention.

### [Reference signs]

- 100:: an organic electroluminescent device
- A:: an organic layer
- 10:: a first electrode
- 20:: a second electrode
- 30:: a hole transport area
- 31:: a hole injection layer
- 32:: a hole transport layer
- 40:: a light emitting layer (an emissive layer)
- 50:: an electron transport area
- 51:: a first electron transport layer
- 52:: a second electron transport layer
- 53:: an electron injection layer

### DETAILED DESCRIPTION OF THE INVENTION

Advantages and features of the present invention and methods for achieving them will become apparent with reference to the embodiments described below in detail in conjunction with the accompanying drawings. However, the present invention is not limited to the embodiments disclosed below but may be implemented in various different forms, the present embodiments are merely provided to make the disclosure of the present invention complete and to fully convey the scope of the present invention to those of ordinary skill in the art, and the present invention is defined only by the scope of the claims. Thus, in some embodiments, well-known process steps, well-known device structures and well-known techniques are not described in detail in order to avoid obscuring the present invention. Like reference numerals refer to like elements throughout the specification.

Unless otherwise defined, all terms used in the present specification (including technical and scientific terms) may be used with meanings that may be commonly understood by those skilled in the art. In addition, the terms defined in the commonly used dictionaries are not ideally or excessively interpreted, unless they are specifically defined clearly.

In addition, throughout the specification, when a part is said to "include" an element, it means that it may further include another element, not excluding other elements, unless otherwise stated. In addition, throughout the specification, "above" or "on" means not only the case where it is located above or below a target part but also the case where there is another part in the middle thereof and does not necessarily mean the upward direction of gravity. As used herein, the terms "first", "second", and the like are used to distinguish elements from each other, rather than indicating any order or importance.

### <Organic electroluminescent device>

Hereinafter, preferred embodiments of the organic EL device according to the present invention will be described with reference to the accompanying drawings. However, embodiments of the present invention may be modified in various other forms, and the scope of the present invention is not limited to the embodiments described below.

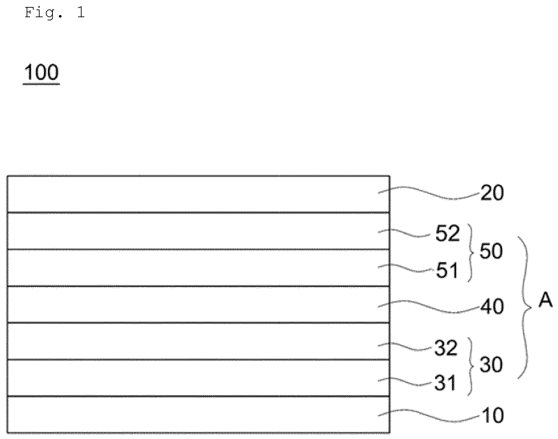

FIG. 1 is a cross-sectional view illustrating a structure of an organic EL device 100 according to a first embodiment of the present invention.

Referring to FIG. 1, the organic electroluminescent device 100 includes: a first electrode 10; a second electrode 20; an light emitting layer 40 located between the first electrode 10 and the second electrode 20; a hole transport area 30 located between the first electrode 10 and the light emitting layer 40; and an electron transport area 50 located between the light emitting layer 40 and the second electrode 20. The electron transport area 50 includes at least two layers, which include: a first electron transport layer 51 disposed adjacent to the light emitting layer 40; and a second electron transport layer 52 disposed adjacent to the second electrode 20 and having a different refractive index from the first electron transport layer 51.

The light efficiency of the organic electroluminescent device (OLED) is largely divided into external quantum efficiency (EQE) and internal quantum efficiency (IQE). Even though the internal quantum efficiency of an OLED is 100%, only light with a low light efficiency of approximately 20-30% may be extracted to the outside during the extraction of light to the outside. Moreover, at the interface between the electrode (metal) and an adjacent organic layer, light may travel along the electrode surface and/or undergo heat loss due to surface plasmon polariton (SPP), and consequently, a significant amount of light generated inside the OLED is wave-guided, and ultimately, approximately 20-30% of the light is extracted to the outside.

However, the present invention is distinguished from conventional organic electroluminescent devices in that at least two electron transport layers 50 are included between the light emitting layer 40 and the second electrode (e.g., a cathode 20) while the refractive index of the first electron transport layer 51 adjacent to the light emitting layer 40 and the refractive index of the second electron transport layer 52 adjacent to the second electrode 20 are precisely controlled to predetermined ranges.

Specifically, in the present invention, the refractive index of the first electron transport layer 51 disposed adjacent to the light emitting layer 40 is controlled to be higher than the refractive index of the second electron transport layer 52 disposed adjacent to the cathode 20 by a predetermined range. In such a case, the light coming from the light emitting layer 40 is emitted upward (in the vertical direction) from the light emitting layer 140 due to a high refractive index of the first electron transport layer 51 adjacent to the light emitting layer, and is then totally reflected due to a low refractive index of the second electron transport layer 52 adjacent to the second electrode 20, thereby enhancing the primary efficiency of light extraction through a micro-cavity effect. This micro-cavity effect improves the emission rate of light by using fine vibrational effects (constructive interference of waves). Even fine waves, when having continuously overlapping identical periods and phases, result in energy amplification, inducing a micro-cavity effect, so that the emitted light can be controlled to be well directed in the vertical direction. In addition, the refractive index of the second electron transport layer 52 adjacent to the second electrode 20 is controlled to be low within a predetermined range, thereby significantly reducing the surface plasmon loss, occurring on the metal of the second electrode 20, through total reflection, and thus the improvement in secondary efficiency through light extraction can be expected.

As such, in the present invention, the micro-cavity effect and the surface plasmon loss are minimized by controlling the arrangement structure between the first electron transport layer 51 and the second electron transport layer 52 and the refractive index difference therebetween, so that the light extraction can be maximized, leading to a synergistic effect in the efficiency of devices.

In an embodiment, the electron transport area 50 including at least two layers with different refractive indexes includes: a first electron transport layer (ET1, 51) disposed adjacent to the light emitting layer 40; and a second electron transport layer (E2, 52) disposed adjacent to the second electrode 20 and having a different refractive index from the first electron transport layer 51. In the wavelength of 460±20 nm, the refractive index (n1) of the first electron transport layer 51 may be higher than the refractive index (n2) of the second electron transport layer 52, and specifically, may be higher by at least 0.05.

Herein, the refractive index is based on a refractive index calculated by the quantum mechanical method CAM-B3LYP/6-31G* using the Lorenz-Lorenz formula. However, the refractive index calculation is not limited thereto, and the use of the measurements or calculations obtained according to methods known in the art also falls within the scope of the present invention.

Since the refractive index of a material varies depending on the wavelength, the refractive index in the present invention is based on the measurements in the blue wavelength range of 460±20 nm. Particularly, on the basis of the green or red wavelength range, a change can be made to a refractive index that is measured in the wavelength range of approximately 520±20 nm or 630±20 nm.

In an embodiment, the refractive index n1 of the first electron transport layer 51 and the refractive index n2 of the second electron transport layer 52 may be 1.45 to 3.0, and specifically, 1.45 to 2.8, respectively, at a wavelength of 460±20 nm.

In another embodiment, in the blue wavelength region of 460±20 nm, the refractive index difference (n1 - n2) between the first electron transport layer 51 and the second electron transport layer 52 may be greater than 0 and less than 1.0, and specifically, may be in a range of 0.1 to 0.8.

In another embodiment, in the wavelength region of 460±20 nm, an absolute value of a refractive index difference between the first electron transport layer 51 and the light emitting layer 40 may be 0 or more and 1.5 or less, and specifically, may be 0.05 or more and 1 or less. Here, the light emitting layer 40 may mean the light emitting layer itself or may mean a host included in the light emitting layer 40.

The organic electroluminescent device 100 according to the present invention preferably satisfies at least one of the following properties in order to exhibit a low driving voltage and a high-efficiency effect, along with the maximization of light extraction by controlling the arrangement stricture of the first electron transport layer 51 and the second electron transport layer 52 and the refractive index difference therebetween.

In an embodiment, the absolute values of the HOMO energy of the first electron transport layer 51 and the second electron transport layer 52 may be 4.0 eV or more, and specifically, 4.0 to 7.0 eV, and more specifically, 4.0 to 6.5 eV, respectively. If the HOMO energy value is such, it is possible to block the phenomenon in which the holes transferred to the light emitting layer 40 diffuse or cross into other electron transport area, for example, the electron transport layers 51 and 52. Accordingly, the efficiency of the organic electroluminescent device may be further increased by increasing the probability of recombination of the holes and electrons encounter in the light emitting layer 40. In addition, the irreversible decomposition reaction caused by oxidation when the holes diffuse or migrate to the electron transport layers 51 and 52 beyond the light emitting layer 40 and the lifetime of the organic electroluminescent device may be reduced, thereby improving the lifetime characteristics of the device.

In another embodiment, the absolute values of the LUMO energy of the first electron transport layer 51 and the second electron transport layer 52 may be 1.60 eV or more, and specifically, 1.60 to 3.50 eV, and more specifically, 1.80 to 3.0 eV, respectively. In addition, in order to generate efficient and high efficiency, the band gap energy of the first electron transport layer 51 and the second electron transport layer 52 may be 2.0 eV or more, and specifically, 2.0 to 4.5 eV, respectively.

In another embodiment, the absolute value of a difference between the HOMO (Highest Occupied Molecular Orbital) energy level of the first electron transport layer 51 and the HOMO energy level of the second electron transport layer 52 may be in a range of 0 to 2.5 eV, and specifically, 0.05 to 2.0 eV.

In another embodiment, the absolute value of a difference between the LUMO (Lowest Unoccupied Molecular Orbital) energy level of the first electron transport layer 51 and the LUMO energy level of the second electron transport layer 52 may be in a range of 0 to 2.5 eV, and specifically, 0.05 to 1.5 eV.

In another embodiment, the absolute value of a difference between the LUMO energy of the light emitting layer 40 and the LUMO energy level of the first electron transport layers (ET1, 51) may be in a range of 0 to 1.5 eV, and specifically, 0.05 to 1.0 eV.

In another embodiment, the absolute value of a difference between the LUMO energy of the light emitting layer 40 and the LUMO energy level of the second electron transport layers (ET2, 52) may be in a range of 0 to 1.5 eV, and specifically, 0.1 to 0.8 eV.

In another embodiment, the absolute value of a difference in molecular weight (MW) between the first electron transport layer 51 and the second electron transport layer 52 may be in a range from 0 to 600 g/mol, and specifically, 0 to 400 g/mol.

In another embodiment, a singlet energy S1 of each of the first electron transport layer 51 and the second electron transport layer 52 may be 1.8 eV or more, specifically 1.8 to 4.5 eV, and more specifically 2.0 to 4.0 eV. In such a case, phenomena that singlet excitons diffuse to an adjacent interface and/or another layer or that luminescence occurs at an interface may be suppressed, and the singlet excitons may be effectively bonded. Accordingly, an amount of excitons is increased, and thus the luminous efficiency of the organic EL device may be improved. As a result, it is possible to prevent spectral mixing of the organic EL device to improve stability, and thus the efficiency and lifespan of the organic EL device may be improved.

In another embodiment, a triplet energy T1 of each of the first electron transport layer 51 and the second electron transport layer 52 may be 1.6 eV or more, specifically 1.6 to 4.5 eV, and more specifically 1.6 to 4.0 eV. In such an embodiment, excitons may be prevented from moving to other layers, and thus the efficiency of the organic EL device may be significantly improved.

In another embodiment, a lowest energy level of bond dissociation energy BDE of each of the first electron transport layer 51 and the second electron transport layer 52 in a ground state may be 0.5 eV or more, specifically 0.5 to 6.0 eV, and more specifically 0.5 to 6.0 eV. In such an embodiment, the bond dissociation energy BDE may be interpreted as an energy required to break a specific chemical bond. In general, the bond dissociation energy BDE is related to stability of molecules as the bond is stronger, and thus acts as a factor affecting the lifespan.

In another embodiment, a dipole moment of the first electron transport layer 51 and the second electron transport layer 52 may be more than 0, and specifically, 0 to 10.

In another embodiment, an electron affinity EA of the first electron transport layer 51 and the second electron transport layer 52 may be at least 0.1 eV or more, specifically 0.1 to 3.0 eV, and more specifically 0.1 to 2.5 eV. In the case where each of the first electron transport layer 51 and the second electron transport layer 52 has the aforementioned electron affinity, high electron injection efficiency may be obtained.

If electrons and holes are not balanced due to a difference between the number of holes injected from the first 10 and the number of electrons injected from the second electrode 20, the electrons or holes that fail to form excitons by recombination may be accumulated in the light emitting layer 40. The electrons or holes accumulated in the light emitting layer 40 interfere with smooth oxidation and reduction from occurring in the light emitting layer 40, or affect adjacent layers, and thus the lifespan of the organic EL device may be reduced. On the other hand, each of the first electron transport layer 51 and the second electron transport layer 52 has an electron mobility (µ) of at least 1×10⁻⁸ cm²/Vs or more at room temperature, such that the delay of the injection of electrons as compared to the number of holes injected from the anode 10 is prevented, and the injection of electrons into the light emitting layer 40 becomes smooth. Accordingly, efficiency of exciton formation in the light emitting layer 40 is increased, and thus the lifespan of the organic EL device may be improved.

Hereinafter, the configuration of the organic EL device 100 according to one embodiment of the present invention including at least two electron transport layers in which the refractive index difference described above is controlled within a predetermined range will be described in more detail.

### Substrate

In the organic electroluminescent device, any substrate that is commonly used in the field of organic light emitting devices can be used, without limitation, as the substrate 110. Considering the mechanical strength, thermal stability, transparency, surface smoothness, ease of handling, water resistance, and the like of organic light-emitting devices, a glass substrate or a transparent plastic substrate is preferred.

### First electrode

In the organic electroluminescent device 100 according to the present invention, the first electrode 10 is disposed on the substrate and serves as an anode that injects holes into an organic material layer A.

The first electrode 10 may be composed of a material with a relatively high work function, thus serving as an anode that injects holes into the adjacent hole transport area 30. Particularly, the second electrode 20 disposed to face the first electrode 10 serves as a cathode that injects electrons into the adjacent electron transport area 50. However, the electrodes are not limited thereto, and in some cases, the first electrode 10 may serve as a cathode, and the second electrode 10 may serve as an anode.

A material forming the first electrode 10 is not particularly limited, and conventional materials known in the art may be used. Non-limiting examples thereof may include metals such as vanadium, chromium, copper, zinc and gold; alloys thereof; metal oxides such as zinc oxide, indium oxide, indium tin oxide (ITO) and indium zinc oxide (IZO); a combination of a metal and an oxide such as ZnO:Al and SnO2:Sb; conductive polymers such as polythiophene, poly(3-methylthiophene), poly[3,4-(ethylene-1,2-dioxy)thiophene] (PEDT), polypyrrole and polyaniline, and carbon black.

A method of manufacturing the first electrode 10 is also not particularly limited and it may be prepared according to conventional methods known in the art. As an example, a method of coating an anode material on a substrate formed of a silicon wafer, quartz, a glass plate, a metal plate or a plastic film may be used.

### Second electrode

In the organic electroluminescent device 100 according to the present invention, the second electrode 20 corresponds to a part that is disposed to face the first electrode 10 and, specifically, is disposed on the electron transport area 50 to serve as a cathode that injects electrons into the organic material layer A.

A material forming the second electrode 20 is not particularly limited, and conventional materials known in the art may be used. Non-limiting examples thereof may include metals such as magnesium, calcium, sodium, potassium, titanium, indium, yttrium, lithium, gadolinium, aluminum, silver, tin, and lead, alloys thereof, and multilayer-structured materials such as LiF/Al and LiO₂/Al.

Particularly, the second electrode 20 is a (semi)transmissive electrode, and an organic electroluminescent device including the second electrode 20 may have a top emission structure. Particularly, the light generated from the light emitting layer 40 may pass through the second electrode 20, but may be reflected on the bottom surface of the second electrode 20. Therefore, repeated reflection may occur between the top surface of the first electrode 10 and the bottom surface of the second electrode 20.

In addition, a method of manufacturing the second electrode 20 is not also particularly limited and it may be prepared according to conventional methods known in the art.

### ORGANIC LAYER

The organic layer A included in the organic EL device according to the present invention may use, without limitation, any conventional configuration used in an organic layer of conventional organic EL devices, and may include, for example, one or more selected from the hole transport area 30, the light emitting layer 40, and the electron transport area 50. In such a case, in consideration of the characteristics of the organic EL device, it is preferable to include all the above-mentioned organic layers.

### HOLE TRANSPORT AREA

The hole transport area 30 included in the organic layer A of the present invention serves to transfer holes injected from the anode 10 to the light emitting layer 40. The hole transport area 30 may include one or more layers including at least one the hole injection layer 31 and the hole transport layer 32 described above. Considering the characteristics of the organic EL device, it is preferable to include all of the hole injection layer 31 and the hole transport layer 32.

In the present invention, materials for the hole injection layer 31 and/or the hole transport layer 32 are not particularly limited, and any hole injection/transport layer material known in the art may be used without limitation, as long as it has a low hole injection barrier and a high hole mobility. In such a case, the materials forming the hole injection layer 31 and the hole transport layer 32 may be the same as or different from each other.

The hole injection material may use, without limitation, any hole injection material known in the art. Non-limiting examples of the hole injection material may include phthalocyanine compounds such as copper phthalocyanine; DNTPD (N,N'-diphenyl-N,N'-bis-[4-(phenyl-m-tolyl-amino)-phenyl]-biphenyl-4,4'-diamine), m-MTDATA (4,4',4"-tris(3-methylphenylphenylamino)triphenylamine), TDATA (4,4'4"-Tris(N,N-diphenylamino)triphenylamine), 2TNATA (4,4',4"-tris{N-(2-naphthyl)-N-phenylamino}-triphenylamine), PEDOT/PSS (poly(3,4-ethylenedioxythiophene)/poly(4-styrenesulfonate)), PANI/DBSA (polyaniline/dodecylbenzenesulfonic acid), PANI/CSA (polyaniline/camphor sulfonic acid), PANI/PSS (polyaniline)/poly(4-styrenesulfonate)), and the like, which may be used solely or as a mixture of two or more thereof.

The hole transporting material may use, without limitation, any hole transporting material known in the art. Non-limiting examples of the hole transporting material may include carbazole-based derivatives such as phenylcarbazole, polyvinylcarbazole or the like; fluorine-based derivatives; triphenylamine-based derivatives such as TPD (N,N'-bis(3-methylphenyl)-N,N'-diphenyl-[1,1-biphenyl]-4,4'-diamine), TCTA (4,4',4"-tris(N-carbazolyl)triphenylamine) or the like; NPB (N,N'-di(1-naphthyl)-N,N'-diphenylbenzidine), TAPC(4,4'-cyclohexylidene bis[N,N-bis(4-methylphenyl)benzenamine]), and the like, which may be used solely or as a mixture of two or more thereof.

The hole transport area 30 may be formed through any conventional method known in the art. Examples of the method may include, but are not limited to, a vacuum deposition method, a spin coating method, a cast method, a Langmuir-Blodgett (LB) method, an inkjet printing method, a laser printing method, a laser-induced thermal imaging (LITI) method, and the like.

### LIGHT EMITTING LAYER

The light emitting layer 40 included in the organic layer A of the present invention is a layer in which holes and electrons meet each other forming excitons, and a color of light emitted by the organic EL device may vary according to the material forming the light emitting layer 40.

Such a light emitting layer 40 may include a host and a dopant, and a mixing ratio thereof may be appropriately adjusted within a range known in the art. For example, the light emitting layer 40 may include the host in an amount ranging from 70 to 99.9 percent by weight (hereinafter, "wt %") and the dopant in an amount ranging from 0.1 to 30 wt %, with respect to the total weight of the light emitting layer 40. More specifically, when the light emitting layer 40 is blue fluorescence, green fluorescence, or red fluorescence, the host may be included in an amount ranging from 80 to 99.9 wt %, and the dopant may be included in an amount ranging from 0.1 to 20 wt %. In addition, when the light emitting layer 40 is blue fluorescence, green fluorescence or red phosphorescence, the host may be included in an amount ranging from 70 to 99 wt % and the dopant may be included in an amount ranging from 1 to 30 wt %.

Any host known in the art may be included in the light emitting layer 40 of the present invention without particular limitation, and non-limiting examples thereof may include alkali metal complex compounds, alkaline earth metal complex compounds, or fused aromatic cyclic derivatives.

More specifically, the host material is preferably aluminum complex compounds, beryllium complex compounds, anthracene derivatives, pyrene derivatives, triphenylene derivatives, carbazole derivatives, dibenzofuran derivatives, dibenzothiophene derivatives, or a combination of one or more kinds thereof that may enhance luminous efficiency and lifespan of the organic EL device.

In addition, any dopant known in the art may be included in the light emitting layer 40 of the present invention without particular limitation, and non-limiting examples thereof may include anthracene derivatives, pyrene derivatives, arylamine derivatives, and metal complex compounds including iridium (Ir) or platinum (Pt).

Such dopants may be classified into red dopants, green dopants, and blue dopants, and any conventional red dopants, green dopants, and blue dopants that are known in the art may be used without particular limitation.

More specifically, non-limiting examples of the red dopant may include PtOEP (Pt(II) octaethylporphyrin), Ir(piq)3 (tris(2-phenylisoquinoline)iridium), Btp2Ir(acac) (bis(2-(2'-benzothienyl)-pyridinato-N,C3')iridium(acetylacetonate)), or a mixture of two or more thereof.

Furthermore, non-limiting examples of the green dopant may include Ir(ppy)3 (tris(2-phenylpyridine)iridium), Ir(ppy)2(acac) (bis(2-phenylpyridine) (acetylacetonato)iridium(III)), Ir(mppy)3 (tris(2-(4-tolyl)phenylpiridine)iridium), C545T (10-(2-benzothiazolyl)-1,1,7,7-tetramethyl-2,3,6,7-tetrahydro-1H,5H,11H-[1]benzopyrano[6,7,8-ij]-quinolizin-11-one), or a mixture of two or more thereof.

Furthermore, non-limiting examples of the blue dopant may include F2Irpic (bis[3,5-difluoro-2-(2-pyridyl)phenyl](picolinato)iridium(III)), (F2ppy)2Ir(tmd), Ir(dfppz)3, DPVBi (4,4'-bis(2,2'-diphenylethen-1-yl)biphenyl), DPAVBi (4,4'-bis[4-(diphenylamino)styryl]biphenyl), TBPe (2,5,8,11-tetra-tert-butylperylene), or a mixture of two or more thereof.

The light emitting layer 40 according to the present invention may be a red light emitting layer including a red phosphorescent material, a green light emitting layer including a green phosphorescent material; or a blue light emitting layer including a blue phosphorescent material or a blue fluorescent material. The light emitting layer 40 may preferably be a light emitting layer including a blue fluorescent material.

The light emitting layer 40 may include a single layer including one type of material, a single layer including a plurality of different materials, or a multi-layer of at least two layers, each including different materials from each other. When the light emitting layer 40 includes a plurality of layers, the organic EL device may emit light having various colors. Specifically, the present invention may provide an organic EL device having mixed colors by including a plurality of light emitting layers, including different kinds of materials, in series. In addition, when the light emitting layer 40 includes a plurality of light emitting layers, the driving voltage of the device may increase, while the current value in the organic EL device become constant, and thus the organic EL device may have luminous efficiency that is improved by the number of the light emitting layers.

Although not illustrated in the drawings, the organic EL device 100 may include a plurality of light emission stacks (not illustrated) including at least one light emitting layer.

The plurality of light emitting layers included in the light emission stack may be light emitting layers that emit light of different colors, or light emitting layers that emit light of the same color. That is, the emission color may vary depending on the material forming the light emitting layer. For example, the plurality of light emission stacks may include a material emitting blue, green, red, yellow, white, or the like, and may be formed using phosphorescent or fluorescent materials. In this case, the colors represented by the light emitting layers may be complementary to each other. In addition, a color may be selected as a combination of colors capable of emitting white light. Each of the light emitting layers may include phosphorescent dopants or fluorescent dopants corresponding to the selected color, respectively.

Although not illustrated in the drawings, the organic EL device 100 may further include a charge generation layer CGL (not illustrated) disposed between adjacent stacks of the plurality of light emission stacks and connecting them.

The charge generation layer CGL means a layer, in the organic EL device including a plurality of light emission stacks, that separates light emission stacks adjacent to each other without directly contacting both electrodes (e.g., anode and cathode). Such a charge generation layer CGL is disposed between two adjacent light emission stacks, generating electrons to serve as a cathode for one light emission stack, and generating holes to serve as an anode for another light emission stack. The charge generation layer CGL may use, without limitation, any material that may be used as a charge generation layer material known in the art. In addition, a conventional n-type and/or p-type material known in the art may be doped to the above material for the charge generation layer.

### ELECTRON TRANSPORT AREA

In the organic EL device 100 according to the present invention, the electron transport area 50 included in the organic layer A serves to transfer electrons injected from the second electrode 20 to the light emitting layer 40.

The electron transport area 50 may include two or more layers, including the first electron transport layer 51 and the second electron transport 52 having different refractive index, and may further include an electron injection layer 53, a hole-leakage suppression layer (not illustrated) and/or an auxiliary electron transport layer (not illustrated) if necessary.

The electron transport area 50 may have a structure in which the first electron transport layer 51 and the second electron transport layer 52 are disposed with respect to the light emitting layer or a structure in which the first electron transport layer 51, the second electron transport layer 52, and the electron injection layer 53 are disposed with respect to the light emitting layer. Considering characteristics of the organic EL device, it is preferable to include all of the first electron transport layer 51, the second electron transport layer 52, and the electron injection layer 53.

The first electron transport layer 51 and the second electron transport layer 52 according to the present invention may each be a material having general electron transport characteristics known in the art without limitation if the difference in refractive indices is controlled to the above-described specific range. For example, the oxadiazole derivative, the triazole derivative, the phenanthroline derivative (e.g., BCP), the heterocyclic derivative including nitrogen, and the like may be included.

In an embodiment, a first compound used as the material of the first electron transport layer 51 and a second compound used as the material of the second electron transport layer 52 may be different from each other, and each may be a compound bonded with at least one moiety, known in the art, having EWG characteristics with high electron absorptivity, and may be, for example, a bipolar compound including both of a moiety having EWG characteristics with high electron absorptivity and a moiety having EDG characteristics with high electron donating properties.

More specifically, the first compound used as the material of the first electron transport layer 51 and the second compound used as the material of the second electron transport layer 52 may include at least one EWG moiety including at least one of a 6-membered moiety represented by the following Formula ; a 5-membered moiety represented by the following Formula 2; and a polycyclic moiety in which the 6-membered moiety and the 5-membered moiety are fused.

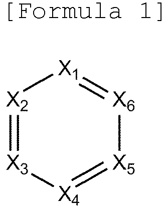

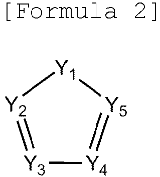

In Formula 1 or 2,
X₁ to X₆ and Y₁ to Y₅ may be the same as or different from each other, each independently being N or C(R), while at least one of X₁ to X₆ and Y₁ to Y₅ is N,
when C(R) is plural in number, the plurality of R may be the same as or different from each other, each independently being selected from the group consisting of: hydrogen, deuterium, a halogen group, a cyano group, a nitro group, an amino group, a C₁ to C₄₀ alkyl group, a C₂ to C₄₀ alkenyl group, a C₂ to C₄₀ alkynyl group, a C₃ to C₄₀ cycloalkyl group, a heterocycloalkyl group having 3 to 40 nuclear atoms, a C₆ to C₆₀ aryl group, a heteroaryl group having 5 to 60 nuclear atoms, a C₁ to C₄₀ alkyloxy group, a C₆ to C₆₀ aryloxy group, a C₁ to C₄₀ alkylsilyl group, a C₆ to C₆₀ arylsilyl group, a C₁ to C₄₀ alkylboron group, a C₆ to C₆₀ arylboron group, a C₆ to C₆₀ arylphosphine group, a C₆ to C₆₀ arylphosphine oxide group and a C₆ to C₆₀ arylamine group, or may be bonded with an adjacent group to form a fused ring,
the alkyl group, the alkenyl group, the alkynyl group, the aryl group, the heteroaryl group, the aryloxy group, the alkyloxy group, the cycloalkyl group, the heterocycloalkyl group, the arylamine group, the alkylsilyl group, the alkylboron group, the arylboron group, the arylphosphine group, the arylphosphine oxide group, and the arylamine group of R may each independently be substituted with one or more kinds of substituents selected from the group consisting of hydrogen, deuterium (D), halogen, a cyano group, a nitro group, a C₁ to C₄₀ alkyl group, a C₂ to C₄₀ alkenyl group, a C₂ to C₄₀ alkynyl group, a C₃ to C₄₀ cycloalkyl group, a heterocycloalkyl group having 3 to 40 nuclear atoms, a C₆ to C₆₀ aryl group, a heteroaryl group having 5 to 60 nuclear atoms, a C₁ to C₄₀ alkyloxy group, a C₆ to C₆₀ aryloxy group, a C₁ to C₄₀ alkylsilyl group, a C₆ to C₆₀ arylsilyl group, a C₁ to C₄₀ alkylboron group, a C₆ to C₆₀ arylboron group, a C₆ to C₆₀ arylphosphine group, a C₆ to C₆₀ arylphosphine oxide group and a C₆ to C₆₀ arylamine group, and when the substituents are plural in number, the substituents may be the same as or different from each other.
The first compound forming the first electron transport layer 51 and the second compound forming the second electron transport layer 52 exhibit excellent electronic properties by including at least one nitrogen (N)-containing heteroaromatic ring containing nitrogen (N), that is, an EWG (electron withdrawing group). Accordingly, when the compound having the 6-membered or 5-membered moiety represented by Chemical Formula 1 or 2, or having a polycyclic moiety in which they are fused is used as a material for the first electron transport layer 51 and the second electron transport layer 52 may well receive electrons from the second electrode 20 to transfer the electrons to the light emitting layer 40 smoothly, and accordingly, the driving voltage of the device 100 may be reduced and high efficiency and long life of the device 100 may be resulted.

In addition, the material of the first electron transport layer 51 and the second electron transport layer 52 not only has a high triplet energy, but also has a molecular weight of the compound significantly increased through the control of various types of substituents introduced into a mother nucleus and location of the introduction, and thus an improved glass transition degree and high thermal stability may be achieved. In addition, since it is also effective in suppressing crystallization of the organic layer, the organic EL device 100 including the first electron transport layer 51 and the second electron transport layer 52 may greatly improve durability and lifespan characteristics.

According to an embodiment of the present invention, the EWG moiety included in each compound forming the first electron transport layer 51 and the second electron transport layer 52 may be embodied as, but not limited to, any one selected from the following structural group.

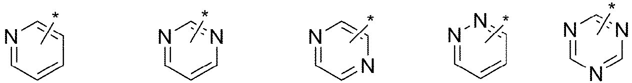

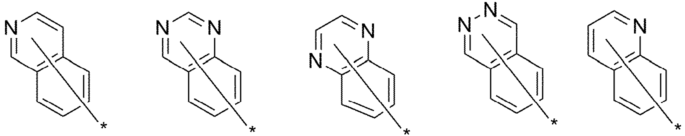

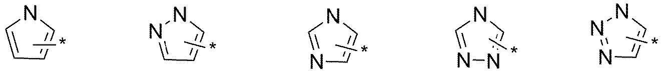

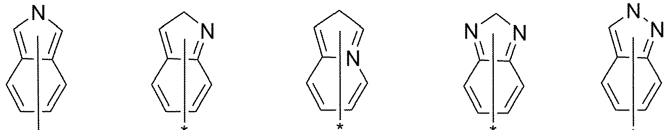

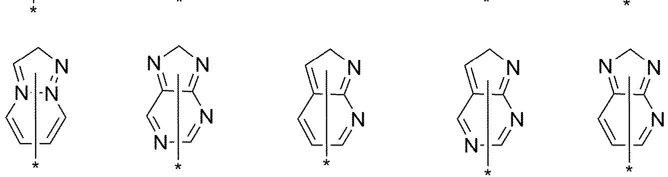

In the above formulas,
* means a site where a bond is made with an each compound that forms a first electron transport layer 51 and a second electron transport layer 52.

Although not specifically indicated in the above structural formulas, at least one or more substituents (e.g., the same as the definition of R) known in the art may be substituted. In addition, although one site * connected to the compound forming the first electron transport layer and the second electron transport layer is shown in the structural formula, it will be understood that a case where two sites are included is within the scope of the present invention.

In an embodiment according to the present invention, each compound forming the first electron transport layer 51 and the second electron transport layer 52 may include at least one conventional EDG moiety known in the pertinent art, other than the aforementioned EWG, that has higher electron donating properties than that of the EWG.

The first compound and the second compound which may be used as materials for the first electron transport layer 51 and the second electron transport layer 52 according to the present invention described above may be more specifically formed by the exemplary compounds described below. However, the first compound and the second compound constituting the first electron transport layer 51 and the second electron transport layer 52 according to the present invention are not limited by those exemplified below. In particular, as long as properties, such as the arrangement structure of the first electron transport layer 51 and the second electron transport layer 52 and the refractive index difference between the layers, are satisfied, the type of moiety (e.g., EDG or EWG) contained in the first compound and the second compound, and binding position thereof, introduction position of a linker are not particularly limited, and compounds with variously modified chemical structures fall within the scope of the present invention.

The electron transport area 50, specifically, the first electron transport layer 51 and the second electron transport layer 52 according to the present invention may be co-deposited with an n-type dopant to facilitate electron injection from the cathode 20. In this case, the n-type dopant may use an alkali metal complex compound known in the art without limitation, and for example, an alkali metal, an alkaline earth metal, a rare earth metal, or the like may be given.

The electron transport area 50 may be manufactured through conventional methods known in the art. Examples thereof may include a vacuum deposition method, spin coating method, cast method, LB (Langmuir-Blodgett), inkjet printing method, laser printing method, LITI (Laser Induced Thermal Imaging) and the like, but are not limited thereto.

### light emitting auxiliary layer

Optionally, the organic EL device 100 according to the present invention may further include a light emitting auxiliary layer (not illustrated) disposed between the hole transport area 30 and the light emitting layer 40.

The light emitting auxiliary layer serves to transfer holes migrating from the hole transport area 30 to the light emitting layer 40 and to control a thickness of the organic layer A. The light emitting auxiliary layer has a high LUMO value to prevent electrons from moving to the hole transport layer 32 and has a high triplet energy to prevent the excitons of the light emitting layer 40 from diffusing into the hole transport layer 32.

The auxiliary light emitting layer may include a hole transporting material and may include a material the same as a material for the hole transport area. In addition, the auxiliary light emitting layers of the red, green, and blue organic EL devices may be formed of the same material.

The material of the light emitting auxiliary layer is not particularly limited, and examples thereof may include carbazole derivatives and arylamine derivatives. Non-limiting examples of the auxiliary light emitting layer that are applicable may include NPD (N, N-dinaphthyl-N, N'-diphenyl benzidine), TPD (N, N'-bis-(3-methylphenyl)-N, N'-bis(phenyl)- benzidine), s-TAD, and MTDATA(4,4',4-Tris(N-3-methylphenyl-Nphenyl-amino)-triphenylamine). They may be used solely or in combination of two or more thereof. In addition, the auxiliary light emitting layer may include a p-type dopant, in addition to the above materials. As the p-type dopant, any well-known p-type dopant used in the art may be used.

### Capping layer

Optionally, the organic EL device 100 of the present invention may further include a capping layer (not illustrated) disposed on the second electrode 20 described above. The capping layer serves to protect the organic EL device and to help light emitted from the organic layer to be efficiently emitted to the outside.

The capping layer may include at least one selected from the group consisting of tris-8-hydroxyquinoline aluminum (Alq3), ZnSe, 2,5-bis(6'-(2',2"-bipyridyl))-1,1-dimethyl-3,4-diphenylsilole, 4'-bis [N-(1-napthyl)-N-phenyl-amion] biphenyl (α-NPD), N,N'-diphenyl-N,N'-bis (3-methylphenyl)-1,1'-biphenyl-4,4'-diamine (TPD), and 1,1'-bis(di-4-tolylaminophenyl) cyclohexane (TAPC). A material forming such a capping layer is less expensive than materials of other layers of the organic EL device.

The capping layer may be a single layer, or may include two or more layers having different refractive indices so that the refractive index gradually changes along the two or more layers.

The capping layer may be manufactured by a conventional method known in the art, and for example, various methods such as vacuum deposition, spin coating, casting, or Langmuir-Blodgett (LB) method may be used.

The organic EL device of the present invention including the above-described configuration may be manufactured according to conventional methods known in the art. For example, the organic EL device may be manufactured by vacuum depositing an anode material on a substrate and then vacuum depositing a material of the hole transport area, a material of the light emitting layer, a material of the electron transport area, and a material of the cathode on the anode in the order.

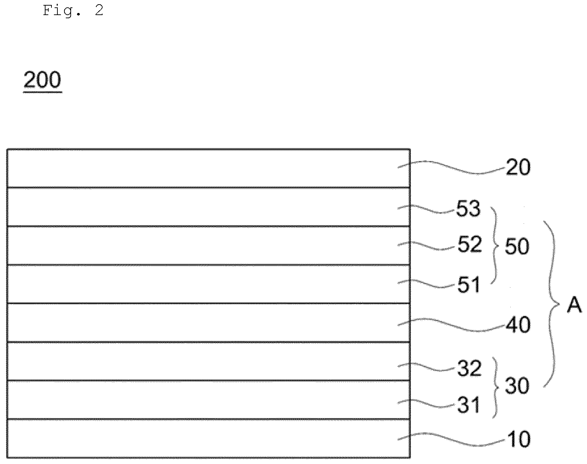

FIG 2 is a cross-sectional view illustrating a structure of the organic electroluminescent device 200 according to another embodiment of the present invention. In FIG 2, the same reference numerals as those of FIG 1 indicate the same elements.

Hereinafter, in the description of FIG 2, the contents overlapping with FIG 1 will not be described again, and only the differences will be described. Referring to FIG. 2, an organic electroluminescent device 200 according to a second embodiment of the present invention has an electron transport area 50 including a first electron transport layer 51, a second electron transport layer 52, and an electron injection layer 53, unlike the embodiment shown in FIG. 1 where the electron transport area 50 is composed of the first electron transport layer 51 disposed adjacent to the light emitting layer 40 and the second electron transport layer 52 disposed adjacent to the second electrode.

Specifically, the electron transport area 50 of FIG. 2 is disposed between the light emitting layer 40 and the second electrode 20, and has a structure in which the first electron transport layer 51, the second electron transport layer 52, and the electron injection layer 53 are disposed with respect to the light emitting layer 40. If necessary, the hole leakgage suppression layer (not illustrated) and/or an auxiliary electron transport layer (not illustrated) may be further included.

The electron injection layer 53 is not particularly limited as long as it is easy to inject electrons and has a high electron mobility, and an electron injection layer material commonly used in the art may be used without limitation. In this case, the materials constituting the second electron transport layer 52 and the electron injection layer 53 may be the same as or different from each other.

Non-limiting examples of electron injection materials that may be used include anthracene derivatives, heteroaromatic compounds, alkali metal complexes, and the like. Specifically, examples thereof may include lanthanum group metals such as LiF, Li2O, BaO, NaCl, CsF, Yb and the like; or a metal halide such as RbCl, RbI, or the like, which may be used solely or in combination of two or more thereof.

The electron injection layer 53 according to the present invention may be co-deposited with a n-type dopant to facilitate the injection of electrons from the cathode. In this case, an alkali metal complex compound known in the art may be used without limitation as the n-type dopant, and examples thereof may include an alkali metal, an alkaline earth metal or a rare earth metal.

The electron injection layer 53 may be formed by, but are not limited to, a vacuum deposition method, a spin coating method, a cast method, a Langmuir-Blodgett (LB) method, an inkjet printing method, a laser printing method, a laser-induced thermal imaging (LITI) method, and the like.

In addition, since the description of the material, structure, and the like of each element in the embodiment of FIG. 2 may be entirely applied to the description of the organic EL device 100 according to the first embodiment of FIG. 1, description thereof will be omitted.

The organic EL devices 100 and 200 according to the present invention described above have a structure in which the first electrode 10, the organic material layer A, and the second electrode 20 are sequentially stacked, and an insulating layer or an adhesive layer may be further included between the first electrode 10 and the organic material layer A or between the second electrode 20 and the organic material layer A. Such an organic EL device of the present invention may have excellent lifespan characteristics since the lifetime (e.g., half-time) of the initial brightness is increased while maintaining the maximum luminous efficiency when voltage, current, or both are applied.

Hereinafter, the present invention will be described in detail through examples. However, the following examples are only to illustrate the present invention, and the present invention is not limited by the following examples.

### [Preparation (Calculation) Example]

The compounds according to the present invention were prepared as follows, and their physical properties were measured by methods known in the art, respectively, which are shown in Table 1 below.

The HOMO energy, the LUMO energy, the singlet energy S1, the triplet energy T1 and the like of the material used in the present invention were calculated using a Schrödinger program (Schrödinger software release 2021-4). Specifically, the basic calculation scheme of each property used the B3LYP functional (Becke, 3-parameter, Lee-Yang-Parr) which is most widely used among density functional theories (DFT), and 6-31* was used as a basis set to optimize the molecular structure.

The HOMO energy and the LUMO energy of each compound were calculated in the ground state S0 with the optimized structure, and each of the singlet energy S1 and the triplet energy T1 was calculated based on the optimized energy difference between the ground state S0/singlet energy S1 and ground state S0/triplet energy T1.

In addition, a refractive index was calculated by using Lorenz-Lorenz's formula with the Cam-B3LYP/6-31G* quantum mechanical method.

In addition, a bond dissociation energy (BDE) and a dipole moment were obtained using the aforementioned B3LYP/6-31* quantum method, and in particular, for the BDE, an energy required to break a certain chemical bond in a molecule is calculated, and a value having a smallest BDE was selected.

**[Table 1]**

| **Compounds for electron transport layer** | | **A refractive index (460nm)** | **HOMO (eV)** | **LUMO (eV)** | **S1 energy (eV)** | **T1 energy (eV)** | **Dipole moment (Debye)** | **BDE (eV)** |
|---|---|---|---|---|---|---|---|---|
| 1 | First_A | 2.11 | -5.13 | -1.78 | 3.10 | 2.28 | 2.22 | 4.75 |
| | Second_A | 1.83 | -6.50 | -1.98 | 3.93 | 2.88 | 1. 08 | 3.21 |
| 2 | First_B | 2.09 | -5.64 | -1.93 | 3.35 | 2.61 | 0.70 | 2.54 |
| | Second_B | 1. 81 | -6.90 | -2.13 | 4.00 | 3.09 | 3.94 | 2.77 |
| 3 | First_C | 2.09 | -5.61 | -1.78 | 3.54 | 2.78 | 2.44 | 3.87 |
| | Second_C | 1.80 | -6.63 | -1.93 | 3.91 | 3.06 | 3.84 | 4.89 |
| 4 | First_D | 2.08 | -5.47 | -1.74 | 3.43 | 2.73 | 1. 98 | 4.12 |
| | Second_D | 1.78 | -6.32 | -1.92 | 3.79 | 3.08 | 3.46 | 4.25 |
| 5 | First_E | 2.05 | -5.32 | -1.73 | 3.27 | 2.544 | 2.55 | 3.46 |
| | Second_E | 1.75 | -6.39 | -2.10 | 3.72 | 2.92 | 3.23 | 3.58 |
| 6 | First_F | 2.17 | -5.77 | -1.74 | 3.64 | 2.63 | 6.83 | 3.92 |
| | Second_F | 1.66 | -6.54 | -2.21 | 3.80 | 2.25 | 4.28 | 3.76 |
| 7 | First_G | 2.00 | -5.40 | -1.85 | 3.26 | 2.35 | 0.91 | 3.57 |
| | Second_G | 1.73 | -6.41 | -1.97 | 3.90 | 2.99 | 0.21 | 4.88 |
| 8 | First_H | 2.02 | -5.75 | -1.84 | 3.62 | 2.96 | 0.22 | 4.08 |
| | Second_H | 2.02 | -5.53 | -1.85 | 3.29 | 2.3 | 2.72 | 3.79 |
| 9 | First_I | 2.98 | -5.1 | -2.11 | 2.68 | 1.58 | 1.57 | 3.94 |
| | Second_I | 1. 98 | -5.82 | -1.89 | 3.45 | 2.71 | 0.69 | 4.17 |
| AE | | 1.96 | -5.58 | -1.82 | 3.44 | 2.67 | 0.50 | 2.78 |
| ET | | 2.22 | -5.73 | -1.84 | 3.45 | 2.59 | 4.06 | 3.47 |
| BH | | 1.90 | -5.12 | -1.62 | 3.15 | 1.73 | 0.05 | 3.89 |

The structure of each compound used in Table 1 above is as follows.

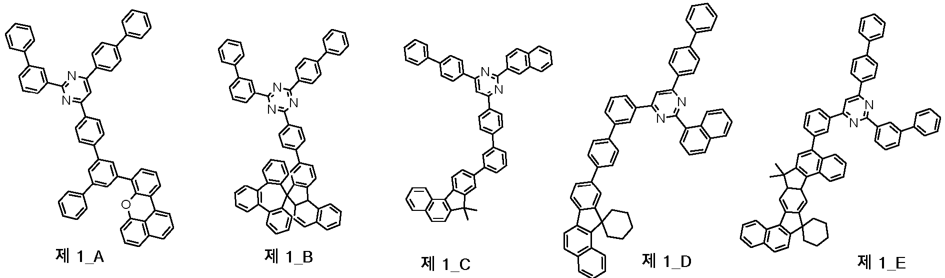

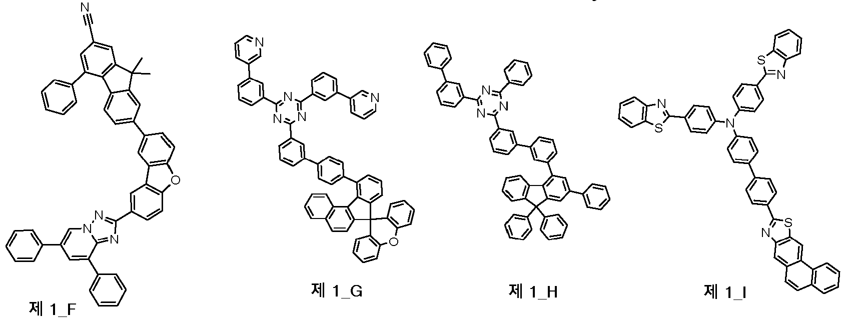

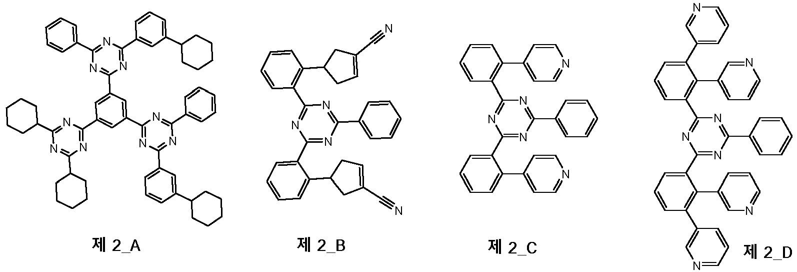

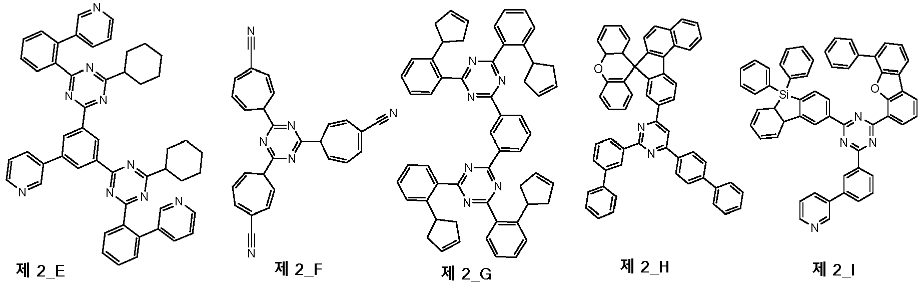

### [Examples 1 to 8] Manufacturing of Blue organic EL device

Each compound wase subjected to high-purity sublimation purification in a conventionally known method, and then blue organic EL device was manufactured according to the following procedure.

A glass substrate thin-film-coated with indium tin oxide (ITO) to a thickness of 1,200 Å was washed with distilled water ultrasonically. After washing with distilled water was completed, the glass substrate was ultrasonically washed with a solvent, such as isopropyl alcohol, acetone and methanol, dried, transferred to a UV OZONE cleaner (Power sonic 405, Hwasin Tech), cleaned for 5 minutes using UV, and then transferred to a vacuum evaporator.

On the ITO transparent electrode prepared as above, HI+2 wt% HD (100 Å)/HI(1400 Å)/HT (50 Å)/BH + 2 wt% BD(200 Å)/EA (50 Å)/ET + Liq (300 Å_1:1)/LiF (10 Å)/Al (1000 Å) ) were stacked in order to manufacture an organic EL device as shown in Table 2.

**[Table 2]**

| | Compounds | Thickness (nm) |
|---|---|---|
| A hole injection layer | HI | 140 |
| A hole transport layer | HT | 5 |
| A light emitting layer | BH + 2% BD | 20 |
| A first electron transport layer | Each compound of first_A to first_G, fisrt_I in Table 1 | 5 |
| A second electron | Each compound of second_A to second_G, second_I in Table 1 | 25 |
| transport layer | | |
| An electron injection layer | LiF | 1 |
| A Cathode (second electrode) | Al | 100 |

In such a case, the structures of Compounds HI, HD, HT, BH, BD, EA and ET are each as follows.

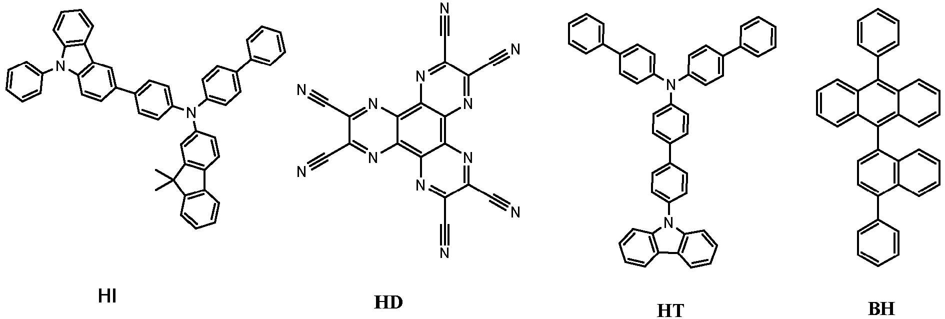

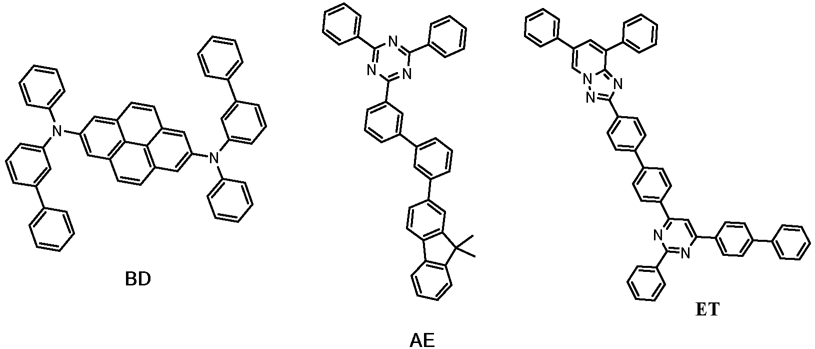

### [Comparative Example 1]

An organic electroluminescent device of Comparative Example 1 was manufactured in the same manner as in Example 1, except that first_H and second_H, which have the same refractive index as each other, were used as materials for the first electron transport layer and the second electron transport layer.

### [Evaluation Example 2]

An organic electroluminescent device of Comparative Example 2 was manufactured in the same manner as in Example 1, except that compounds AE and ET were used as materials for the first electron transport layer and the second electron transport layer.

### [Evaluation Example 3]

For each of the organic EL devices manufactured in Examples (Ex.) 1 to 8 and Comparative Examples (Comp. Ex.) 1 to 2, a driving voltage, and a current efficiency at a current density of 10 mA/cm² were measured, and the results are shown in Table 3 below.

**[Table 3]**

| Examples | ET1 | ET2 | A difference in refactive index (ET1-ET2) | Driving voltage (V) | Current efficiency (cd/A) |
|---|---|---|---|---|---|
| Ex. 1 | First A | Second_A | 0.23 | 3.98 | 8.3 |
| Ex. 2 | First B | Second_B | 0.28 | 3.95 | 8.5 |
| Ex. 3 | First C | Second_C | 0.29 | 3.90 | 8.8 |
| Ex. 4 | First_D | Second_D | 0.30 | 3.81 | 9.0 |
| Ex. 5 | First_E | Second_E | 0.32 | 3.79 | 9.1 |
| Ex. 6 | First_F | Second_F | 0.50 | 3.72 | 9.8 |
| Ex. 7 | First_G | Second_G | 0.27 | 3.93 | 8.6 |
| Ex. 8 | First_I | Second_I | 1 | 4.19 | 6.1 |
| Comp. Ex. 1 | First_H | Second_H | 0 | 4.07 | 6.3 |
| Comp. Ex. 2 | AE | ET | -0.26 | 4.28 | 6.0 |

As shown in Table 3, the organic electroluminescent devices of Examples 1 to 8, which are composed of two electron transport layers with different refractive indexes, wherein the refractive index of a first electron transport layer adjacent to an light emitting layer is controlled to be higher than that of the other electron transport layers, were excellent in terms of driving voltage and current efficiency characteristics of devices, compared with Comparative Examples 1 to 3.

Specifically, the organic electroluminescent device of Comparative Example 1 including a first electron transport layer and a second electron transport layer with the same refractive index and the organic electroluminescent device of Comparative Example 2 including a first electron transport layer having a smaller refractive index than a second electron transport layer showed poor properties in terms of driving voltage and current efficiency characteristics of devices. Moreover, the device of Example 8 where the refractive index difference between a first electron transport layer and a second electron transport layer is somewhat large also showed relatively low performance. However, the organic electroluminescent devices of Examples 1 to 7 where the refractive index difference between a first electron transport layer and a second electron transport layer was controlled within a predetermined range were superior in terms of driving voltage and current efficiency characteristics of devices.

## Claims

1. An organic electroluminescent device, comprising a structure in which a first electrode, a hole transport area, a light emitting layer, an electron transport area, and a second electrode are sequentially laminated,
wherein the electron transport area includes at least two layers,
the at least two layers including:
a first electron transport layer (ET1) disposed adjacent to the light emitting layer; and
a second electron transport layer (ET2) disposed adjacent to the second electrode, and
in the wavelength range of 460±20 nm, the refractive index (n1) of the first electron transport layer being higher than the refractive index (n2) of the second electron transport layer.

2. The organic electroluminescent device of claim 1, wherein in the wavelength range of 460±20 nm, the difference in refractive index (n1 - n2) between the first electron transport layer and the second electron transport layer is greater than 0 and less than 1.0.

3. The organic electroluminescent device of claim 1, wherein in the wavelength range of 460±20 nm, each of the refractive indexes (n1) of the first electron transport layer and the second electron transport layer is 1.45 to 3.0.

4. The organic electroluminescent device of claim 1, wherein in the wavelength range of 460±20 nm, an absolute value of a refractive index difference between the first electron transport layer and the light emitting layer is 0 to 1.5.

5. The organic electroluminescent device of claim 1, wherein in the wavelength range of 460±20 nm, an absolute value of a refractive index difference between the second electron transport layer and the light emitting layer is 0 to 1.5.

6. The organic electroluminescent device of claim 1, wherein each of absolute value of HOMO energy of the first electron transport layer and the second electron transport layer is 4.0 eV or higher.

7. The organic electroluminescent device of claim 1, wherein each of absolute value of LUMO energy of the first electron transport layer and the second electron transport layer is 1.60 eV or higher.

8. The organic electroluminescent device of claim 1, wherein an absolute value of a difference between a HOMO energy level of the first electron transport layer and a HOMO energy level of the second electron transport layer is 0 to 2.5 eV.

9. The organic electroluminescent device of claim 1, wherein an absolute value of a difference between a LUMO energy level of the first electron transport layer and a LUMO energy level of the second electron transport layer is 0 to 2.5 eV.

10. The organic electroluminescent device of claim 1, wherein an absolute value of a difference between a LUMO energy level of the light emitting layer and a LUMO energy level of the first electron transport layer is 0 to 1.5 eV.

11. The organic electroluminescent device of claim 1, wherein an absolute value of a difference between a LUMO energy level of the light emitting layer and a LUMO energy level of the second electron transport layer is 0 to 1.5 eV.

12. The organic electroluminescent device of claim 1, wherein the absolute value of a difference in molecular weight (MW) between the first electron transport layer and the second electron transport layer is from 0 to 600 g/mol.

13. The organic electroluminescent device of claim 1, wherein each of a single energy (S1) of the first electron transport layer and the second electron transport layer is 1.8 eV or higher.

14. The organic electroluminescent device of claim 1, wherein each of a triplet energy (T1) of the first electron transport layer and the second electron transport layer is 1.6 eV or higher.

15. The organic electroluminescent device of claim 1, wherein a lowest energy level among a bonding dissociation energy (BDE) of a ground state of the first electron transport layer and the second electron transport layer is 0.5 eV or more.

16. The organic electroluminescent device of claim 1, wherein the first electron transport layer and the second electron transport layer each have a dipole moment greater than 0.

17. The organic electroluminescent device of claim 1, wherein the first electron transport layer and the second electron transport layer each have an electronic affinity (EA) of 0.1 eV or more.

18. The organic electroluminescent device of claim 1, wherein the first electron transport layer and the second electron transport layer have an electron mobility (µ) of at least 1×10⁻⁸ cm²/Vs or more in a zero-field.

19. The organic electroluminescent device of claim 1, wherein the electron transport area further comprises at least one layer selected from the group consisting of a hole leakage suppression layer, an auxiliary electron transport layer, and an electron injection layer.

20. The organic electroluminescent device of claim 1, wherein the light emitting layer includes a host and a dopant, and a mixing ratio of the host and dopant is 70-99.5: 0.5-30 in a weight ratio.

21. The organic electroluminescent device of claim 1, comprising a plurality of light emitting layer stacks including at least one light emitting layer.
